# EUROPEAN PATENT SPECIFICATION

(11) **EP 1 630 248 B1**
(45) Date of publication and mention of the grant of the patent: **02.05.2012**
(21) Application number: 04745508.4
(22) Date of filing: 02.06.2004
(51) Int. Cl.: C23C 14/56, C23C 14/58, C23C 14/00

(54) **THIN FILM FORMING METHOD**
VERFAHREN ZUR AUSBILDUNG VON DÜNNEM FILM
PROCEDE DE FABRICATION D'UN FILM MINCE

(30) Priority: 03.06.2003 JP 2003158253
(43) Date of publication of application: 01.03.2006
(73) Proprietor: Shincron Co., Ltd., Kanagawa 220-8680 (JP)
(72) Inventor: SONG, Yizhou, Kawaguchi-shi, Saitama, 332-0011 (JP); SAKURAI, Takeshi, Yokohama-shi, Kanagawa, 223-0052 (JP)
(74) Representative: Grünecker, Kinkeldey, Stockmair & Schwanhäusser
(86) International application number: PCT/JP2004/007609
(87) International publication number: WO 2004/108981

(56) References cited:
- EP-A- 0 719 874
- EP-A- 0 940 481
- EP-A1- 0 409 451
- EP-A1- 0 945 523
- JP-A- 6 172 990
- JP-A- 11 279 757
- JP-A- 2000 119 846
- JP-A- 2001 011 605
- SONG Y. ET AL: 'Optical and structural properties of dense SiO2, Ta2O5 and Nb2O5 thin-films deposited by indirectly reactive sputtering technique' VACUUM vol. 59, 2000, pages 755 - 763, XP002981338

## Description

### BACKGROUND OF THE INVENTION

### Field of the Invention

The present invention relates to a method of manufacturing a thin film and a sputtering apparatus, particularly to a method of manufacturing a thin film, and a sputtering apparatus, in which sputtering is performed to form a thin film having desired optical characteristics on a substrate.

### Description of the Related Art

Attempts have heretofore been made to design an optical thin film using limited materials in the natural world in order to design optical spectral characteristics required for a certain product group. However, when the optical thin film is designed using the limited materials in this manner, the design becomes complicated, and it has been difficult to obtain the thin film having arbitrary optical characteristics.

Therefore, it has been necessary to obtain a material having an arbitrary refractive index and decay coefficient, that is, a material which does not exist in the natural world.

For example, to constitute a wide-band reflection preventive film, a material is required which hardly exists in the natural world and which has an intermediate refractive index (between 1.46 and 2.20). For example, as to glass, in general, when a reflectance of glass is set to a low reflectance in a general visible light range, a material is required to have a refractive index in a range of 1.46 to 2.20. The reflectance is referred to as the intermediate refractive index. The following techniques are known in which the above-described intermediate refractive index is obtained.

That is, the followings have been known: a technique for simultaneously evaporating from separate evaporation sources a low-refractive material {e.g., SiO₂ (refractive index: 1.46)} and a high-refractive material {e.g., TiO₂ (refractive index: 2.35)} to obtain the intermediate refractive index (1.46 to 2.40) by a mixture ratio; a technique for mixing the low and high-refractive materials, and evaporating the materials simultaneously from one evaporation source to obtain the intermediate refractive index by the mixture ratio; an equivalent film technique for equivalently obtaining the intermediate refractive index by a combination of the low and high-refractive materials and the like.

Moreover, as a technique capable of arbitrarily controlling the refractive index and capable of obtaining a metal compound thin film whose optical or mechanical characteristics and the like are stabilized, a technique is known in which after sputtering on a substrate each target comprising a low-refractive material {e.g., SiO₂ (refractive index: 1.46)} and a high-refractive material {e.g., TiO₂ (refractive index: 2.35)} to form a super thin film comprising a composite metal, an active seed of a reactive gas such as oxygen is brought into contact with the super thin film, and the super thin film is reacted with the active seed of the reactive gas, and converted into a compound of the composite metal. This step is repeated until a compound thin film of the composite metal is formed on the substrate. The thin film has a desired film thickness and optical characteristics (e.g., Japanese Patent Application Laid-Open No. 09-263937 (pages 2 and 3, FIG. 1)).

In this technique, each target is sputtered comprising at least two or more independent heterogeneous metals, the super thin film is formed comprising a composite metal or an incomplete reactant of the composite metal on the substrate, the formed super thin film is brought into contact and reacted with the active seed of a reactive gas mixed with an inactive gas having a chemically inactive property, and the film is converted into the compound of the composite metal. This step is repeated until arbitrary optical characteristics are obtained within a range of the original optical property of the compound of a single metal constituting the compound thin film of the composite metal (e.g., Japanese Patent Application Laid-Open No. 2001-011605 (pages 2 to 4, FIG. 1)).

JP2000119846 discloses deposition of titanium and silicon on a substrate and rotation of the substrate past an oxidation station with a freely selectable speed.

Furthermore, a method is also known in which a flow rate of the reactive gas is adjusted when introduced into a reaction or film-forming process zone, and accordingly optical characteristics are adjusted such as a refractive index and a decay coefficient with respect to the formed thin film.

However, there has been a problem that it is difficult to control the refractive index and obtain a process having a stabilized quality in the technique for evaporating the low and high-refractive materials simultaneously from the separate evaporation sources to obtain the intermediate refractive index by the mixture ratio, the technique for mixing the low and high-refractive materials, and evaporating the materials simultaneously from one evaporation source to obtain the intermediate refractive index by the mixture ratio, the equivalent film technique for equivalently obtaining the intermediate refractive index by the combination of the low and high-refractive materials and the like.

To solve the problem, the technique is known in which after sputtering on the substrate each target comprising the low and high-refractive materials to form the super thin film comprising the composite metal, the super thin film is brought into contact and reacted with the active seed of the reactive gas like oxygen, and converted into the component of the composite metal. This step is repeated until the compound thin film of the composite metal is formed on the substrate. The thin film has the desired film thickness and optical characteristics.

It is to be noted that the term "super thin film" is used in order to prevent confusion with the "thin film" because the super thin film is deposited a plurality of times and formed into a final thin film, and it is meant the super thin film is sufficiently thinner than the final "thin film".

According to this technique, the refractive index can be arbitrarily controlled, and the metal compound thin film can be obtained whose optical or mechanical characteristics and the like are stabilized. However, at least two or more types of a plurality of metals need to be used as the target. Although the metal compound thin film comprising the composite metal can be obtained, there has been a problem that it is difficult to form the thin film whose refractive index is arbitrarily controllable and whose optical and mechanical characteristics and the like are stabilized by the use of the single metal only.

To solve the problem, the technique is known in which in the use of the single metal only as the target, the flow rate of the reactive gas is adjusted when introduced in performing the sputtering, and the optical characteristics of the formed thin film are adjusted. The optical characteristics include the refractive index, decay coefficient and the like.

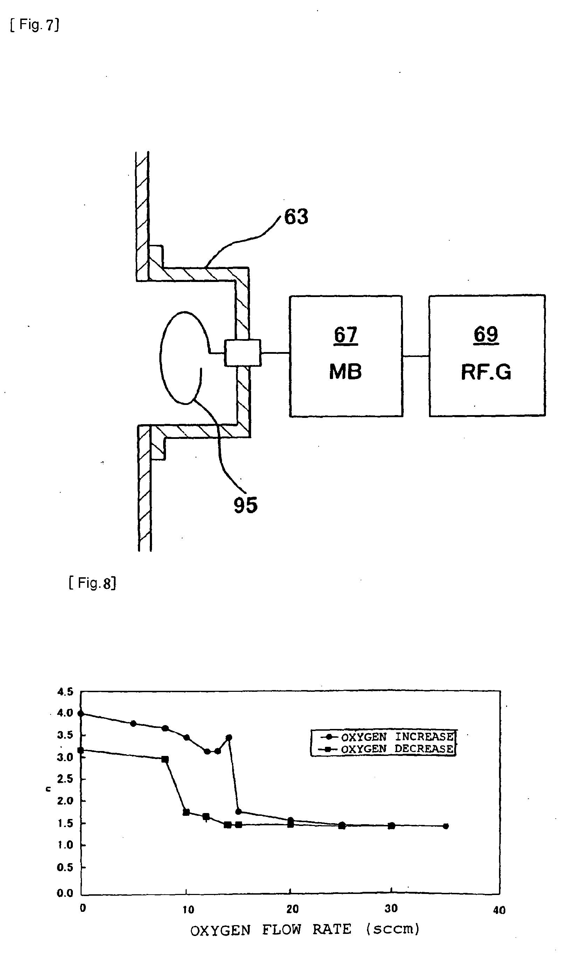

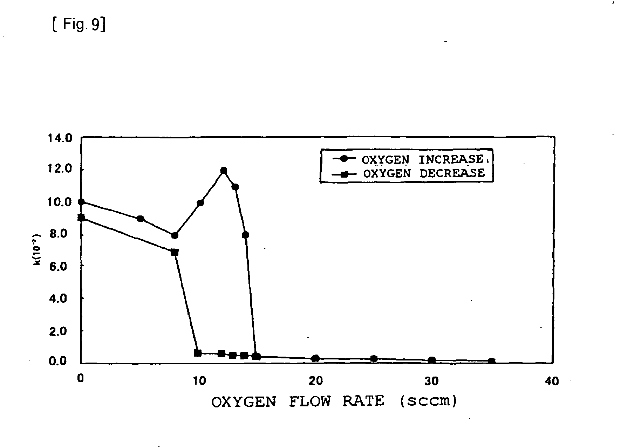

As shown in FIGS. 8, 9, for example, when oxygen is used as the reactive gas, it is possible to adjust the refractive index and the decay coefficient which are the optical characteristics of the thin film formed by changing an oxygen flow rate in a range in which the oxygen flow rate is excessively high or low, for example, in a relation between the oxygen flow rate and the optical characteristics of the thin film which are the refractive index and decay coefficient. However, a graph rapidly changes in a range in which the oxygen flow rate is 15 sccm or less and which does not include 0 sccm, and the oxygen flow rate needs to be strictly adjusted in order to form the thin film having the refractive index and decay coefficient which are obtained by the use of the oxygen flow rate in this range.

As shown in FIGS. 8, 9, when the oxygen gas flow rate increases or decreases, a so-called hysteresis phenomenon occurs where change routes differ in the refractive index and decay coefficient which are the optical characteristics of the thin film. Therefore, it is more difficult to control the optical characteristics of the thin film by adjusting the oxygen gas flow rate.

Thus, when forming the thin film having a refractive index in a range of about 1.5 to 3.5, and a decay coefficient in a range of about 1.0×10⁻³ to 12.0×10⁻³, the oxygen flow rate needs to be strictly adjusted.

Therefore, in the method in which the oxygen flow rate is adjusted to thereby form the thin film having the refractive index and decay coefficient in the above-described ranges, reproducibility is unsatisfactory depending on a range of the oxygen flow rate, and it is very difficult to form the thin film having the desired optical characteristics with a high reproducibility. Therefore, there has been a demand for a technique for forming the thin film having the refractive index and decay coefficient which are the optical characteristics in these ranges.

### SUMMARY OF THE INVENTION

The present invention has been developed in view of the above-described problems, and an object is to provide a thin film manufacturing method for manufacturing a thin film with a high reproducibility. The thin film has optical characteristic values in a region in which a hysteresis phenomenon occurs where a change route of the optical characteristic value differs with respect to a reactive gas flow rate, when a flow rate of a reactive gas is increased or decreased by the use of a single metal only.

According to the present invention, there is provided a method of forming a thin film, comprising the features of claim 1

Thus, the substrate holder is formed in such a manner as to be movable between the film formation process zone to perform the intermediate thin film forming step and a reaction process zone to perform the film composition converting step, and the moving speed of the substrate holder can be adjusted. Then, it is possible to adjust a sputtering time in the film formation process zone and a reaction time of the intermediate thin film with the active seed of the reactive gas in the reaction process zone. Therefore, the composition of the finally formed thin film can be adjusted, and it is possible to easily form with a high reproducibility the thin film having the optical characteristic value in the region where the hysteresis phenomenon occurs. The region is a range in which it is difficult to control the optical characteristic value of the thin film.

At this time, in the optical characteristic adjusting step, the substrate holder is rotated/driven. The holder holds the substrate on an outer peripheral face thereof, and has a cylindrical shape or a hollow polygonal pole shape. A rotation speed of the substrate holder is preferably controlled to thereby form the thin film of the optical characteristic value of the region in which the hysteresis phenomenon occurs.

Consequently, the substrate held by the substrate holder is repeatedly smoothly conveyed between the film formation process zone and the reaction process zone, and the rotation speed of the substrate holder is controlled, so that a stable conveying speed control is possible.

Moreover, it is possible to form the thin films at once by sputtering with respect to a large number of substrates held on the outer peripheral face of the substrate holder, and a mass production of the thin films is possible.

Furthermore, the region in which the hysteresis phenomenon occurs is the region of the optical characteristic value of the thin film formed at a reactive gas flow rate introduced when performing the sputtering. The flow rate is 15 sccm or less, and does not include 0 sccm.

In the region, since a ratio of the change of the optical characteristic is large with respect to a change of the reactive gas flow rate, and the hysteresis phenomenon occurs, it is very difficult to control the optical characteristic of the formed thin film by the adjusting of the reactive gas flow rate. Therefore, in the region, instead of adjusting the reactive gas flow rate, the rotation speed of the substrate holder is adjusted to thereby control the optical characteristic of the formed thin film, and it is possible to form the thin film having the desired optical characteristic with the high reproducibility.

Other advantages and the like of the present invention will be apparent from the following description.

### BRIEF DESCRIPTION OF THE DRAWINGS

FIG. 1 is an explanatory view showing a sputtering apparatus ;
FIG. 2 is a transverse section explanatory view along a line A-B-C of FIG. 1 showing the sputtering apparatus of ;
FIG. 3 is a graph showing dependence of a thin film optical characteristic on a substrate holder rotation speed;
FIG. 4 is a graph showing dependence of the thin film optical characteristic on the substrate holder rotation speed;
FIG. 5 is an explanatory view of a constitution example of a plasma source;
FIG. 6 is an explanatory view of a constitution example of the plasma source;
FIG. 7 is an explanatory view of a constitution example of the plasma source;
FIG. 8 is a diagram showing dependence of a thin film refractive index on an oxygen flow rate; and
FIG. 9 is a diagram showing dependence of a thin film decay coefficient on the oxygen flow rate.

### DESCRIPTION OF THE PREFERRED EMBODIMENT

The present invention is an invention relating to a method of manufacturing a thin film on a substrate. An embodiment of the present invention will be described hereinafter with reference to the drawings. It is to be noted that members, arrangement of the members and the like described hereinafter do not limit the present invention, and can be variously modified within, the scope of the present invention.

In the present embodiment, film formation and reaction of an intermediate thin film are repeatedly performed to form a thin film in order to obtain a targeted optical characteristic value and film thickness.

A range of a targeted optical characteristic value of the thin film indicate optical characteristic values in a region wherein a hysteresis phenomenon occurs in which a change route of the optical characteristic value changes with respect to a reactive gas flow rate in a case where a flow rate of a reactive gas is increased and in a case where the rate is decreased. The reactive gas is introduced in sputtering a single type or a plurality of types of metals to form the thin film

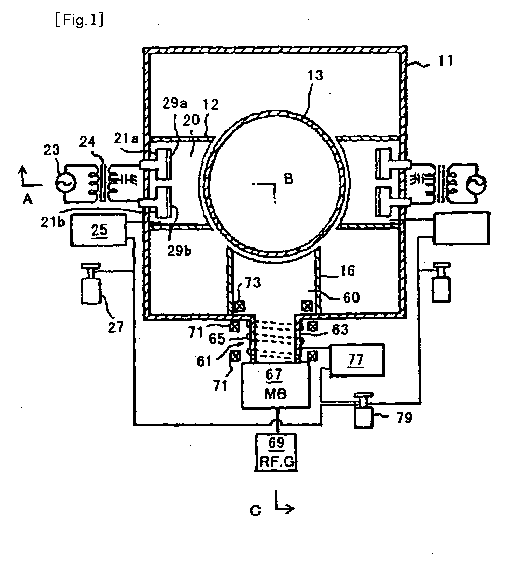

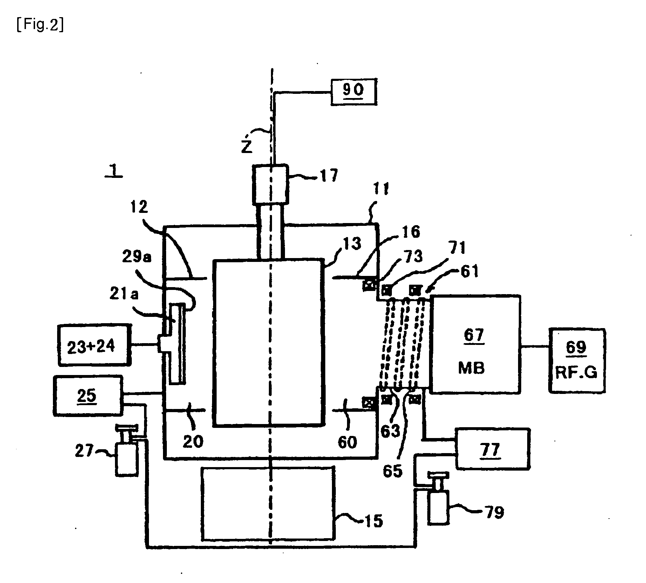

FIG. 1 is an explanatory view showing a sputtering apparatus of the present embodiment. FIG. 2 is a transverse section explanatory view along a line A-B-C of FIG. 1. In the present embodiment, the sputtering apparatus is used for performing magnetron sputtering which is one example of sputtering, but the present invention is not limited to this apparatus. Another sputtering apparatus is usable which performs another known sputtering such as two-pole sputtering without using magnetron discharge.

Main constituting elements of a sputtering apparatus 1 of the present embodiment include: a vacuum tank 11; a substrate holder 13 for holding in the vacuum tank 11 a substrate (not shown) on which a thin film is to be formed; a servo motor 17 which is substrate holder driving means for driving the substrate holder 13; a control device 90 which is substrate holder conveying speed controlling means for controlling the servo motor 17; a film formation process zone 20 to perform an intermediate thin film forming step; a reaction process zone 60 in which an intermediate thin film formed in the film formation process zone is brought into contact with an active seed of a reactive gas mixed with an inactive gas to perform a film composition converting step; partition walls 12, 16 which is partitioning means for forming the reaction process zone 60; magnetron sputtering electrodes 21a, 21b which are sputtering electrodes; an alternating-current power supply 23; and an active seed generation device 61 which is active seed generating means for generating an active seed.

It is to be noted that in the present specification, the intermediate thin film is formed of a metal or a metal incomplete oxide, and is formed in the film formation process zone.

The vacuum tank 11 is formed of stainless steel usually used in a known sputtering apparatus, and a hollow member having a substantially rectangular parallelepiped shape. The vacuum tank 11 may have a hollow cylindrical shape. The bottom face of the vacuum tank 11 is connected to exhaust piping. As shown in FIG. 2, this piping is connected to a vacuum pump 15 for exhausting in the vacuum tank 11. A vacuum degree in the vacuum tank 11 can be adjusted by the vacuum pump 15 and a controller (not shown).

The substrate holder 13 is disposed substantially in a middle in the vacuum tank 11. The substrate holder 13 has a cylindrical shape, and holds a plurality of substrates on its outer peripheral face. The substrate holder 13 may have a hollow polygonal pole shape, or a substantially conical hollow shape instead of the cylindrical form. The substrate holder 13 is electrically insulated from the vacuum tank 11, and has a floating state in a potential manner. The substrate holder 13 is disposed in the vacuum tank 11 in such a manner that a central axial line Z in a cylindrical direction of a cylinder extends in a vertical direction of the vacuum tank 11. While a vacuum state in the vacuum tank 11 is maintained, the substrate holder 13 is rotated/driven centering on the central axial line Z by the servo motor 17 disposed above the vacuum tank 11.

The servo motor 17 is a known servo motor, and is controlled by the control device 90 which is controlling means. The substrate holder 13 rotates by the driving of the servo motor 17, and a rotation speed is arbitrarily controlled in a range of 10 rpm to 150 rpm.

The outer peripheral face of the substrate holder 13 is provided with substrate holding means (not shown) for holding the substrates on the substrate holder 13, the substrate holding means is provided with concave portions (not shown) in which the substrates are to be stored, and the concave portions are formed in a row in a vertical direction.

In the present embodiment, it is assumed that the substrate having a flat plate shape is used whose face (hereinafter referred to as the "film forming face") for forming the thin film extends in parallel with a face (hereinafter referred to as the "substrate back face") opposite to the film forming face. A base constituting the substrate holding means is formed into such a shape that the surface of the concave portion facing the substrate back face turns in a direction vertical to the central axial line Z of the substrate holder 13, when the substrate is held. Therefore, the film forming face of the substrate turns to the direction vertical to the central axial line Z of the substrate holder 13.

The film formation process zone 20 and the reaction process zone 60 are formed by the partition walls 12, 16 fixed in the vacuum tank 11. The film formation process zone 20 is formed in a surrounded state by the partition wall 12, and the reaction process zone 60 is formed in a surrounded state by the partition wall 16.

In the present embodiment, the partition wall 16 is fixed in the vacuum tank 11 in such a manner that the reaction process zone 60 is formed in a position rotated from a position where the film formation process zone 20 is formed by about 90 degrees on a circumference centering on a rotation axis of the substrate holder 13.

When the substrate holder 13 is rotated/driven by the servo motor 17, the substrate held by the substrate holder 13 is conveyed between a position facing the film formation process zone 20 and a position facing the reaction process zone 60. Accordingly, the substrate relatively moves with respect to targets 29a, 29b disposed in the film formation process zone 20 as described later.

It is to be noted that the partition walls 12, 16 in the present embodiment are cylindrically rectangular parallelepiped member whose pair of faces facing each other are opened, and is formed of stainless steel. The partition walls 12, 16 are fixed between a side wall of the vacuum tank 11 and the substrate holder 13 in a vertically extended state from the side wall of the vacuum tank 11 toward the substrate holder 13. In this case, one opened side of each of the partition walls 12, 16 abuts on the side wall of the vacuum tank 11, and the other opened side is fixed in the vacuum tank in such a manner as to face the substrate holder 13. In each of the partition walls 12, 16, a piping for water cooling (not shown) is attached in such a manner as to cool the partition walls 12, 16.

The film formation process zone 20 is connected to a mass flow controller 25 which is gas introducing means via a piping. The mass flow controller 25 is connected to a sputtering gas container 27 to store an argon gas which is an inactive gas, and is connected to a reactive gas container 79 to store a reactive gas. The reactive gas can be introduced from the reactive gas container 79 into the film formation process zone 20 through the piping under control by the mass flow controller 25. Examples of the reactive gas are supposed to include an oxygen gas, nitrogen gas, fluorine gas, ozone gas and the like.

The magnetron sputtering electrodes 21a, 21b are disposed on a wall surface of the vacuum tank 11 in such a manner as to face the outer peripheral face of the substrate holder 13 in the film formation process zone 20. The magnetron sputtering electrodes 21a, 21b are fixed to the vacuum tank 11 disposed in a ground potential via an insulating member (not shown). The magnetron sputtering electrodes 21a, 21b are connected to the alternating-current power supply 23 via a transformer 24, and are constituted in such a manner that an alternating electric field is applicable. The magnetron sputtering electrodes 21a, 21b hold the targets 29a, 29b. The targets 29a, 29b have flat plate shapes, and are held in such a manner that the surfaces of the targets 29a, 29b facing the outer peripheral face of the substrate holder 13 are directed in a direction vertical to the central axial line Z of the substrate holder 13.

It is to be noted that, although not shown, a movable pre-sputtering shield is disposed between the targets 29a, 29b and the substrate holder 13 in the film formation process zone 20 in such a manner as to interrupt or open between the targets 29a, 29b and the substrate holder 13. When starting sputtering, the pre-sputtering shield interrupts between the targets 29a, 29b and the substrate holder 13 until the sputtering is stably performed. After the sputtering is stably performed, the shield opens between the targets 29a, 29b and the substrate holder 13 to thereby deposit sputtering atoms on the substrate after the sputtering is stabilized.

An opening is formed in the wall face of the vacuum tank 11 of the reaction process zone 60, and connected to the active seed generation device 61 which is active seed generating means.

The active seed generation device 61 is referred to also as a radical source, and comprises: a reactive gas plasma generation chamber 63 comprising a quartz tube for generating reactive gas plasmas; an coiled electrode 65 wound around the reactive gas plasma generation chamber 63; a matching box 67; a high-frequency power supply 69 connected to the coiled electrode 65 via the matching box 67; a mass flow controller 77; and the reactive gas container 79 connected via the mass flow controller 77.

As to the plasmas generated by electric discharge in the reactive gas plasma generation chamber 63 of the active seed generation device 61, constituting elements are plasma ions, electrons, radicals, radicals having excited states, atoms, molecules and the like.

The active seed of the reactive gas in the plasma generated in the reactive gas plasma generation chamber 63 can participate in a reaction process in the reaction process zone 60.

The active seeds of the reactive gas are ions, radicals and the like. The radicals are free radicals, and atoms or molecules having one or more unpaired electrons. The excited state indicates a state having energy higher than that of a stable base state having lowest energy.

The reactive gas, for example, an oxygen gas is supplied into the reactive gas plasma generation chamber 63 from the reactive gas container 79 via the mass flow controller 77, and a high-frequency power is applied to the coiled electrode 65 from the high-frequency power supply 69 via the matching box 67. Then, the plasma of the reactive gas is generated in the reactive gas plasma generation chamber 63.

Moreover, as shown in FIGS. 1, 2, external magnets 71 are disposed outside the reactive gas plasma generation chamber 63, and inner magnets 73 are disposed in the reaction process zone 60. The external magnets 71 and inner magnets 73 have function of forming a magnetic field of 20 to 300 gausses and thereby generating high-density plasmas in a plasma generation section to enhance an active seed generation efficiency. It is to be noted that in the present embodiment, both the external magnet 71 and the inner magnet 73 are disposed, but either one of the external magnet 71 and the inner magnet 73 may be disposed.

A method of manufacturing a thin film will be hereinafter described using the above-described sputtering apparatus 1 of the present embodiment in accordance with an example for manufacturing a silicon oxide (SiO₂) dielectric thin film.

It is to be noted that in the present specification, the example will be described in which silicon or niobium is used as the target, but the usable target is not limited to a single type of metal. That is, even when a plurality of types of metals are used as targets, a rotation speed of the substrate holder is controlled in a range in which a hysteresis phenomenon occurs, so that optical characteristics of the thin film can be controlled.

### (Step of forming thin film of silicon oxide)

First, the substrate and the targets 29a, 29b are disposed in the sputtering apparatus 1. The substrate is held in the substrate holder 13 by the substrate holding means. The targets 29a, 29b are held by the magnetron sputtering electrodes 21a, 21b, respectively. Silicon (Si) is used as materials of the targets 29a, 29b.

A targeted range of an optical characteristic value of the thin film is a region where the hysteresis phenomenon occurs in which a change route of the optical characteristic value with respect to a reactive gas flow rate differs in a case where the flow rate of the reactive gas is increased and a case where the rate is decreased. The reactive gas is introduced in sputtering the targets comprising a single type or a plurality of types of metals.

The hysteresis phenomenon is a phenomenon in which a value of B differs with respect to the same A depending on the route of the change of A in a case where the other amount B changes with the change of a certain amount A.

The present specification indicates a phenomenon in which values of a refractive index, decay coefficient and the like indicating the optical characteristics of the thin film change in the different routes in the increase and decrease route of the flow rate of the reactive gas introduced when sputtering the targets comprising a single type or a plurality of types of metals.

Next, the vacuum tank 11 is decompressed to a predetermined pressure, the servo motor 17 is operated, and rotation of the substrate holder 13 is started.

A rotation speed of the substrate holder 13 is selected from a range of 10 rpm to 100 rpm, preferably 10 rpm to 60 rpm in such a manner that the thin film having the desired optical characteristics is formed, and the control device 90 is set.

Subsequently, after the pressure in the vacuum tank 11 is stabilized, the pressure in the film formation process zone 20 is adjusted to 1.0×10⁻¹ to 1.3 Pa.

Next, an argon gas which is an inactive gas for sputtering is introduced together with an oxygen gas which is a reactive gas into the film formation process zone 20 via the sputtering gas container 27 and the reactive gas container 79 while flow rates are adjusted by the mass flow controller 25, and an atmosphere for performing the sputtering is adjusted in the film formation process zone 20.

In this case, the flow rate of the argon gas introduced into the film formation process zone 20 is about 300 sccm. The flow rate of the oxygen gas introduced in the film formation process zone 20 is adjusted into a desired value as described later. It is to be noted that a flow rate unit sccm indicates a flow rate per minute at 0°C in 101325 Pa, and is equal to cm³/min.

Next, an alternating-current voltage having a frequency of 1 to 100 KHz is applied to the magnetron sputtering electrodes 21a, 21b from the alternating-current power supply 23 via the transformer 24, so that an alternating electric field is applied to the targets 29a, 29b. Accordingly, the target 29a forms a cathode (minus pole) at a certain time. In this case, the target 29b necessarily forms an anode (plus pole). When a direction of an alternating current changes at the next time, the target 29b forms the cathode (minus pole), and the target 29a forms the anode (plus pole). When a pair of targets 29a, 29b alternately form the anode and cathode, a plasma is formed, and the target on the cathode is sputtered.

When starting the sputtering, the pre-sputtering shield interrupts between the targets 29a, 29b and the substrate holder 13 until the sputtering is performed stably. After the sputtering is stably performed, the shield opens between the targets 29a, 29b and the substrate holder 13. Accordingly, after the sputtering is stabilized, sputtering atoms can be deposited on the substrate.

While the sputtering is performed, nonconductive or low-conductive incomplete silicon oxide, silicon oxide or the like sometimes stick to the anode. When the anode is converted into the cathode by the alternating electric field, incomplete silicon oxide or the like is sputtered, and the target surface is brought into an original clean state.

Moreover, when the pair of targets 29a, 29b repeatedly alternately form the anode and cathode, a stable anode potential state is constantly obtained, a plasma potential (usually substantially equal to an anode potential) is prevented from being changed, and incomplete silicon oxide is stably formed on the film forming face of the substrate.

When the sputtering is performed in the film formation process zone 20 in this manner, an intermediate thin film comprising silicon or incomplete silicon oxide is formed on the film forming face of the substrate. The incomplete silicon oxide is an incomplete reactant in the present invention, and indicates incomplete silicon oxide SiOₓ (x < 2) lacking in oxygen which is a constituting element of silicon oxide SiO₂.

A composition of a material constituting the intermediate thin film is determined by adjusting of the flow rate of the oxygen gas introduced into the film formation process zone 20, and a film thickness of the intermediate thin film is determined by the adjusting of the rotation speed of the substrate holder 13.

That is, a relation is formed between the flow rate of the oxygen gas introduced into the film formation process zone 20, and a stoichiometric coefficient x of incomplete silicon oxide SiOₓ (x < 2) constituting the intermediate thin film, and the relation indicates that a value of the stoichiometric coefficient x increases with an increase of the flow rate of the introduced oxygen gas.

Moreover, when the rotation speed of the substrate holder 13 is raised, a sputtering time in the film formation process zone shortens. Therefore, the number of particles deposited on the substrate is reduced, and the film thickness of the intermediate thin film decreases.

In the present embodiment, the flow rate of the introduced oxygen gas is adjusted into a desired value in such a manner that silicon or incomplete silicon oxide having a desired stoichiometric coefficient x is formed on the film forming face of the substrate, the rotation speed of the substrate holder 13 is adjusted in such a manner as to form a desired film thickness, and the sputtering is performed in the film formation process zone 20. While the sputtering is performed, the intermediate thin film comprising silicon or incomplete silicon oxide is formed on the film forming face of the substrate, while rotating/driving the substrate holder 13 at a predetermined rotation speed to move the substrate holder 13.

Furthermore, although not shown, correction and shield plates are disposed between the magnetron sputtering electrodes 21a, 21b and the substrate holder 13, and the intermediate thin film may be formed in such a manner as to have a film thickness distribution in accordance with the shape of the shield plate.

The intermediate thin film comprising silicon or incomplete silicon oxide is formed on the film forming face of the substrate in the film formation process zone 20. Accordingly, after performing an intermediate thin film forming step, the substrate is conveyed from a position facing the film formation process zone 20 to that facing the reaction process zone 60 by the rotating/driving of the substrate holder 13.

In the present embodiment, in the reaction process zone 60, the silicon or incomplete silicon oxide constituting the intermediate thin film is oxidized/reacted and converted into silicon oxide (SiO₂) to thereby perform a film composition converting step.

An oxygen gas which is a reactive gas is introduced into the reaction process zone 60 from the reactive gas container 79. A high-frequency power of 100 KHz to 50 MHz is applied to the coiled electrode 65 to generate plasmas by the active seed generation device 61. It is to be noted that the pressure of the reaction process zone 60 is maintained at 7.0×10⁻² to 1.0 Pa. The active seeds of the reactive gas exist in the plasmas in the reactive gas plasma generation chamber 63, and the active seeds of the reactive gas are introduced into the reaction process zone 60.

Moreover, the substrate holder 13 rotates, and the substrate is conveyed to the position facing the reaction process zone 60. The intermediate thin film comprising silicon or incomplete silicon oxide has been formed on the substrate. Then, in the reaction process zone 60, a step is performed to oxidize/react silicon or incomplete silicon oxide constituting the intermediate thin film. That is, silicon or incomplete silicon oxide is oxidized/reacted by the active seed of the oxygen gas, and converted into a silicon oxide (SiO₂).

At this time, the rotation speed of the substrate holder 13 is adjusted to thereby determine the composition of the intermediate thin film.

When the rotation speed of the substrate holder 13 is increased, the film thickness decreases on the intermediate thin film formed in the film formation process zone 20, and the reaction is facilitated in the reaction process zone 60. Therefore, a conversion ratio of silicon, incomplete silicon oxide (SiOₓ) into silicon oxide (SiO₂) increases in the reaction process zone.

That is, in the reaction process zone 60, an amount of silicon, incomplete silicon oxide (SiOₓ) converted into silicon oxide (SiO₂) changes depending on the rotation speed of the substrate holder 13. The composition of the formed thin film changes depending on the rotation speed of the substrate holder 13.

Therefore, when the rotation speed of the substrate holder 13 is adjusted, it is possible to adjust the composition of silicon, incomplete silicon oxide (SiOₓ), silicon oxide (SiO₂) constituting a finally formed thin film. The optical characteristics of the finally formed thin film are determined.

When the rotation speed of the substrate holder 13 is adjusted in this manner, the composition of the thin film is determined, and it is possible to form the thin film having the desired optical characteristic.

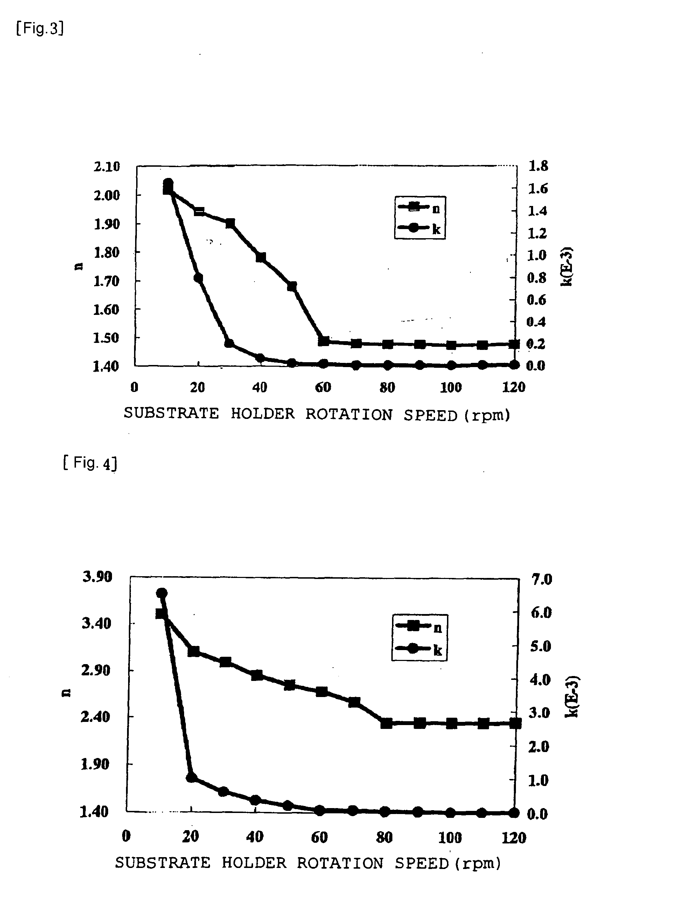

FIG. 3 is a graph showing a relation between the rotation speed of the substrate holder 13 and the optical characteristic of the formed thin film.

A refractive index and a decay coefficient are selected as parameters of evaluation of the optical characteristics of the formed thin film, the abscissa indicates a substrate holder rotation speed (rpm), and the ordinate indicates the refractive index and decay coefficient.

As shown in FIG. 3, according to the method of forming the thin film according to the present embodiment, the refractive index of the formed thin film can be controlled into 2.02 to 1.475 with the increase of the rotation speed of the substrate holder 13, and the decay coefficient can be controlled into 1.6×10⁻² to 5.0×10⁻⁵.

In the present embodiment, the rotation speed (rpm) of the substrate holder 13 is determined in such a manner as to form the thin film having desired refractive index and decay coefficient based on FIG. 3.

It is to be noted that the optical characteristics of the thin film were evaluated using measurement data of a spectral ellipso meter.

Table 1 is a table showing the rotation speed of the substrate holder and a substrate passing time in the film formation process zone and reaction process zone in the present embodiment.

**[Table 1]**

| Rotation speed (rpm) | Film forming rate before reaction (nm/s) | Sputtering time (s) | Film thickness before reaction (nm) | Reaction time (s) |
|---|---|---|---|---|
| 150 | 0.2 | 5.63E-2 | 1.13E-2 | 5.39E-2 |
| 140 | 0.2 | 6.04E-2 | 1.21E-2 | 5.77E-2 |
| 130 | 0.2 | 6.50E-2 | 1.30E-2 | 6.22E-2 |
| 120 | 0.2 | 7.04E-2 | 1.41E-2 | 6.74E-2 |
| 110 | 0.2 | 7.68E-2 | 1.54E-2 | 7.35E-2 |
| 100 | 0.2 | 8.45E-2 | 1.69E-2 | 8.08E-2 |
| 90 | 0.2 | 9.39E-2 | 1.88E-2 | 8.98E-2 |
| 80 | 0.2 | 1.06E-1 | 2.11E-2 | 1.01E-1 |
| 70 | 0.2 | 1.21E-1 | 2.41E-2 | 1.15E-1 |
| 60 | 0.2 | 1.41E-1 | 2.82E-2 | 1.35E-1 |
| 50 | 0.2 | 1.69E-1 | 3.38E-2 | 1.62E-1 |
| 40 | 0.2 | 2.11E-1 | 4.23E-2 | 2.02E-1 |
| 30 | 0.2 | 2.82E-1 | 5.63E-2 | 2.69E-1 |
| 20 | 0.2 | 4.23E-1 | 8.45E-2 | 4.04E-1 |
| 10 | 0.2 | 8.45E-1 | 1.69E-1 | 8.08E-1 |

When the rotation speed of the substrate holder is adjusted in this manner, it is possible to control a sputtering time in the film formation process zone and a reaction time in the reaction process zone. As a result, it is possible to control the composition of the finally formed thin film.

Moreover, in the film composition converting step in the reaction process zone 60, a final thin film is formed in such a manner that the film thickness of the final thin film is larger than that of the intermediate thin film.

That is, when converting, into silicon oxide (SiO₂), silicon or incomplete silicon oxide SiOₓ (x < 2) constituting the intermediate thin film, the intermediate thin film is expanded, and the film thickness of the final thin film is set to be larger than that of the intermediate thin film.

An expansion ratio depends on the flow rate of the oxygen gas introduced in the film formation process zone 20. That is, the flow rate of the oxygen gas introduced in the film formation process zone 20 is decreased in the intermediate thin film forming step in the film formation process zone 20. There is a relation such that an increase ratio of the film thickness increases with reduction of the value of the stoichiometric coefficient x of incomplete silicon oxide. In other words, in the intermediate thin film forming step, the flow rate of the oxygen gas introduced in the film formation process zone 20 is adjusted to thereby determine the stoichiometric coefficient x (when x is set to 0, the intermediate thin film comprises silicon) of incomplete silicon oxide constituting the intermediate thin film, and an increase ratio of the film thickness of the final thin film can be determined with respect to the intermediate thin film.

As described above, in the present embodiment, the rotation speed of the substrate holder is controlled, and the intermediate thin film forming step and the film composition converting step are repeated, while rotating the substrate holder 13 on which the substrate is mounted. Accordingly, the formation of silicon or incomplete silicon oxide (SiOₓ (x < 2)) onto the substrate is repeated in the film formation process zone 20. The conversion of silicon or incomplete silicon oxide SiOₓ into silicon oxide (SiO₂) is repeated in the reaction process zone 60. The thin film can be formed which has the desired film thickness and the desired optical characteristics.

The step of sputtering silicon to form the thin film has been described, and niobium can be similarly sputtered to form the thin film. FIG. 4 is a graph of a niobium oxide dielectric thin film showing a relation between the rotation speed of the substrate holder 13 and the optical characteristics of the formed thin film.

A refractive index and a decay coefficient are selected as parameters of evaluation of the optical characteristics of the formed thin film, the abscissa indicates a substrate holder rotation speed (rpm), and the ordinate indicates the refractive index and decay coefficient.

As shown in FIG. 4, according to the method of forming the thin film according to the present embodiment, the refractive index of the formed thin film can be controlled into 3.50 to 2.35 with the increase of the rotation speed of the substrate holder 13, and the decay coefficient can be controlled into 6.5×10⁻² to 5.0×10⁻⁵.

In the present embodiment, the rotation speed (rpm) of the substrate holder 13 is determined in such a manner as to form the thin film having desired refractive index and decay coefficient based on FIG. 4.

Operating conditions will be described hereinafter in a case where silicon is sputtered to form a thin film and a case where niobium is sputtered to form a thin film.

### (1) Sputtering conditions of silicon

Supplied power: 7.0 kW
Substrate temperature: room temperature
Pressure in film formation process zone: 1.3 Pa
Applied alternating-current voltage frequency: 40 KHz
Complete compound rate: 0.40 nm/s

### (2) Sputtering conditions of niobium

Supplied power: 4.5 kW
Substrate temperature: room temperature
Pressure in film formation process zone: 1.3 Pa
Applied alternating-current voltage frequency: 40 KHz
Complete compound rate: 0.35 nm/s

### (3) Driving conditions of active seed generation device

Device: inductive coupling generation source shown in FIGS. 1, 2
Supplied power: 2.0 kW
Pressure: 6.5×10⁻¹ Pa

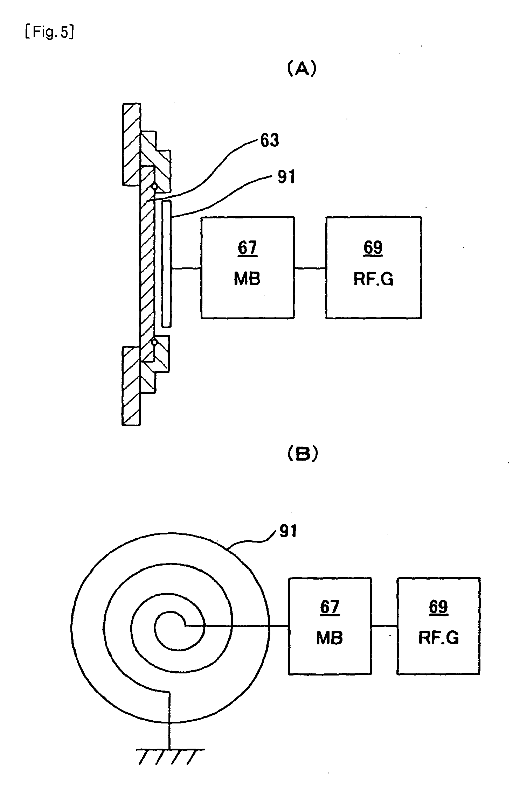

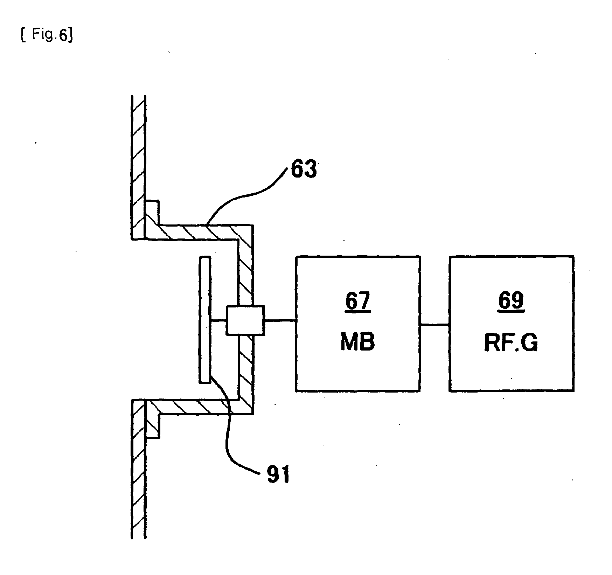

In the present embodiment, silicon and niobium were used as materials of the targets, but the materials are not limited to them, and the materials of the targets 29a, 29b can be variously changed.
(a) Metals are usable such as aluminum (Al), titanium (Ti), zirconium (Zr), tin (Sn), chromium (Cr), tantalum (Ta), tellurium (Te), iron (Fe), magnesium (Mg), hafnium (Hf), nickel•chromium (Ni-Cr), and indium•tin (In-Sn). Compounds of these metals are also usable such as Al₂O₃, TiO₂, ZrO₂, Ta₂O₅, SiO₂, HfO₂.
   When these targets are used, by the contact of the active seeds of the reactive gas in the reaction process zone 60, the film is formed: for example, an optical or insulating film of Al₂O₃, TiO₂, ZrO₂, Ta₂O₅, HfO₂, MgF₂ or the like; a conductive film of ITO or the like; a magnetic film of Fe₂O₃ or the like; or a super hard film of TiN, CrN, TiC or the like.
(b) In the above-described embodiment, as shown in FIG. 1, the reactive gas is introduced into the film formation process zone 20 and the reaction process zone 60 from the same reactive gas container 79, but the present invention is not limited to this constitution. The film formation process zone 20 and the reaction process zone 60 may be connected to different gas containers so that different gases having the same element can be introduced.
   In the above-described embodiment, oxygen is introduced as the reactive gas into the film formation process zone 20 and reaction process zone 60. Additionally, various gases can be introduced such as: an oxidizing gas of ozone, nitrogen oxide (N₂O) or the like; a nitriding gas of nitrogen or the like; a carbonic gas of methane or the like; a fluoric gas of fluorine, carbon fluoride (CF₄) or the like. It is to be noted that when a nitrogen gas is introduced into the film formation process zone 20, the introduced gas flow rate may be set to 300 sccm of argon gas which is an inactive gas, and 9 to 60 sccm of nitrogen gas.
(c) In the present embodiment, as shown in FIGS. 1, 2, as a reactive gas plasma section, an inductive coupling plasma source is used in which the electrodes are disposed outside or inside the reactive gas plasma generation chamber. As described later, other sources are usable: an inductive coupling plasma source in which a coiled electrode is disposed in the reactive gas plasma generation chamber (the following (1)); a capacity coupling plasma source (the following (2)); an inductive capacity coupling mixed plasma source (the following (3)).
   (1) Plasma source shown in FIG. 5: an inductive coupling plasma generation source in which a spiral (pyrethrum-coil-shaped) electrode 91 is disposed on an atmospheric side of a reactive gas plasma generation chamber 63 comprising a dielectric like disc-shaped quartz glass, and a high-frequency power of 100 KHz to 50 MHz is applied to the spiral electrode 91 to generate plasmas. FIG. 5(B) is a substantially explanatory plan view of the spiral electrode 91.
   (2) Plasma source shown in FIG. 6: a capacity coupling plasma generation source in which a flat-plate-shaped electrode 93 is disposed in a reactive gas plasma generation chamber 63, and a high-frequency power of 100 KHz to 50 MHz is applied to the flat-plate-shaped electrode 93 to generate plasmas.
   (3) Plasma source shown in FIG. 7: a plasma generation source in which a coiled electrode 95 or a spiral electrode is disposed in the reactive gas plasma generation chamber 63, and a high-frequency power of 100 KHz to 50 MHz is applied to the electrode to generate mixed plasmas of inductive coupling and capacity coupling plasmas. When the shape or the like of the coil is adjusted, a helicon wave plasma source is constituted, and a generation efficiency of active seeds in the plasma can be enhanced.
(d) In the above-described embodiment, a so-called carousel type sputtering apparatus is used, but the present invention is not limited to the device. That is, any sputtering device may be used as long as the substrate holder can be repeatedly conveyed between the film formation process zone and the reaction process zone, and the conveying speed can be controlled unless the substrate holder is rotated/driven.

For example, a sputtering apparatus may be constituted in such a manner as to repeatedly move the substrate holder in parallel. The processes in the intermediate thin film forming step and film composition converting step are similar to those of the method of manufacturing the thin film using the sputtering apparatus 1 described in the above-described embodiment. When the conveying speed of the substrate holder is adjusted, the sputtering time and reaction time are adjusted, and the optical characteristics of the formed thin film can be determined.

## Claims

1. A method of forming a thin film, comprising:
an intermediate thin film forming step of sputtering a target (29a, 29b) comprising a single type or a plurality of types of metals to form an intermediate thin film comprising the metal or an incomplete reactant of the metal onto a substrate;
a film composition converting step of bringing the formed intermediate thin film into an active seed of a reactive gas mixed with an inactive gas having a chemically inactive property in such a manner that the intermediate thin film is reacted with the active seed of the reactive gas, and converted into a compound of the metal; wherein the active seed of the reactive gas is selected from ion, radicals, and the likes; and **characterized by**
an optical characteristic adjusting step of repeatedly conveying a substrate holder (13) between a zone (20) to perform the intermediate thin film forming step and a zone (60) to perform the film composition converting step while controlling a conveying speed of the substrate holder (13) for holding the substrate, repeatedly performing the intermediate thin film formation and the film composition conversion, and accordingly adjusting a film composition of a finally formed thin film to form the thin film having an optical characteristic value of a region where a hysteresis phenomenon occurs in which a change route of the optical characteristic value differs with a reactive gas flow rate in a case where a flow rate of the reactive gas is increased and a case where the flow rate is decreased.

2. The thin film forming method according to claim 1, wherein the optical characteristic adjusting step comprises the steps of: rotating/driving the substrate holder (13) holding the substrate on an outer peripheral face and having a cylindrical or hollow polygonal columnar shape; and controlling a rotation speed of the substrate holder (13) to form the thin film having the optical characteristic value in the region where the hysteresis phenomenon occurs.

3. The thin film forming method according to claim 1, wherein the region where the hysteresis phenomenon occurs is a region of the optical characteristic value of the thin film formed when the reactive gas introduced in performing the sputtering has a flow rate of 15 sccm or less, which does not include 0 sccm.

## Patentansprüche

1. Verfahren zum Ausbilden einer Dünnschicht, das umfasst:
einen Schritt zum Ausbilden einer Zwischen-Dünnschicht, in dem ein Target (29a, 29b), das einen einzelnen Typ Metall oder mehrere Typen von Metallen umfasst, gesputtert wird, um eine Zwischen-Dünnschicht, die das Metall oder einen unvollständigen Reaktanten des Metalls umfasst, auf einem Substrat auszubilden;
einen Schritt zum Umwandeln einer Schichtzusammensetzung, in dem die ausgebildete Zwischen-Dünnschicht in einen aktiven Keim eines reaktiven Gases, das mit einem inaktiven Gas gemischt ist, das chemisch inaktiv ist, so eingebracht wird, dass die Zwischen-Dünnschicht mit dem aktiven Keim des reaktiven Gases zur Reaktion gebracht wird, und in eine Verbindung des Metalls umgewandelt wird, wobei der aktive Keim des reaktiven Gases aus Ionen, Radikalen und dergleichen ausgewählt wird; und
**gekennzeichnet durch**
einen Schritt zum Anpassen optischer Charakteristik, in dem ein Substrat-Halter (13) wiederholt zwischen einer Zone (20) zum Durchführen des Schrittes zum Ausbilden einer Zwischen-Dünnschicht und einer Zone (60) zum Durchführen des Schrittes zum Umwandeln der Schichtzusammensetzung transportiert wird und dabei eine Transportgeschwindigkeit des Substrat-Halters (13) zum Halten des Substrats gesteuert wird, die Ausbildung der Zwischen-Dünnschicht und die Umwandlung der Schichtzusammensetzung wiederholt durchgeführt werden und dementsprechend eine Schichtzusammensetzung einer abschließend ausgebildeten Dünnschicht angepasst wird, um die Dünnschicht auszubilden, die einen Wert der optischen Charakteristik eines Bereiches hat, in dem ein Hysterese-Phänomen auftritt, bei dem sich ein Änderungsverlauf des Wertes der optischen Charakteristik mit einer Strömungsgeschwindigkeit des reaktiven Gases in einem Fall, in dem eine Strömungsgeschwindigkeit des reaktiven Gases erhöht wird, und einem Fall unterscheidet, in dem die Strömungsgeschwindigkeit verringert wird.

2. Verfahren zum Ausbilden einer Dünnschicht nach Anspruch 1, wobei der Schritt zum Anpassen der optischen Charakteristik die folgenden Schritte umfasst:
Drehen/Antreiben des Substrathalters (13), der das Substrat an einer Außenumfangsfläche hält und eine zylindrische oder hohle polygonale Säulenform hat, und
Steuern einer Drehgeschwindigkeit des Substrathalters (13), um die Dünnschicht auszubilden, die den Wert der optischen Charakteristik in dem Bereich hat, in dem das Hysterese-Phänomen auftritt.

3. Verfahren zum Ausbilden einer Dünnschicht nach Anspruch 1, wobei der Bereich, in dem das Hysterese-Phänomen auftritt, ein Bereich des Wertes der optischen Charakteristik der Dünnschicht ist, die ausgebildet wird, wenn das beim Durchführen des Sputtern eingeleitete reaktive Gas eine Strömungsgeschwindigkeit von 15 sccm oder weniger hat, wobei dies 0 sccm nicht einschließt.

## Revendications

1. Procédé de formation de couche mince comprenant :
une étape de formation de couche mince intermédiaire consistant à pulvériser une cible (29a, 29b) comprenant un type unique ou une pluralité de types de métaux pour former une couche mince intermédiaire comprenant le métal ou un réactif incomplet du métal sur un substrat ;
une étape de conversion de composition de couche pour amener la couche mince intermédiaire formée en un germe actif d'un gaz réactif mélangé avec un gaz inactif ayant une propriété chimiquement inactive de telle manière que la couche mince intermédiaire réagisse avec le germe actif du gaz réactif et soit convertie en un composé du métal dans lequel le germe actif du gaz réactif est choisi parmi un ion, des radicaux et analogue ; et **caractérisé par**
une étape de réglage des caractéristiques optiques pour acheminer de façon répétée un support de substrat (13) entre une zone (20) pour exécuter l'étape de formation de couche mince intermédiaire et une zone (60) pour exécuter l'étape de conversion de composition de couche en commandant la vitesse de convoyage du support de substrat (13) pour maintenir le substrat, exécuter de manière répétée la formation de couche mince intermédiaire et la conversion de composition de couche et en conséquence, régler la composition de couche d'une couche mince finalement formée pour former la couche mince ayant une valeur de caractéristique optique d'une région où se produit un phénomène d'hystérésis dans lequel une route variable de la valeur de caractéristique optique diffère du flux de gaz réactif dans le cas où le flux du gaz réactif augmenté et dans le cas où le flux diminue.

2. Procédé de formation de couche mince selon la revendication 1, dans lequel l'étape de réglage des caractéristiques optiques comprend les étapes consistant à faire tourner/entraîner le support de substrat (13) maintenant le substrat sur une face périphérique extérieure et ayant une forme de colonne polygonale cylindrique ou creuse ; et commander la vitesse de rotation du support de substrat (13) pour former la couche mince ayant la valeur de caractéristique optique dans la région où se produit le phénomène d'hystérésis.

3. Procédé de formation de couches minces selon la revendication 1, dans lequel la région où se produit le phénomène d'hystérésis est une région de la valeur de caractéristique optique de la couche mince formée lorsque le gaz réactif introduit lors de l'exécution de la pulvérisation présente un débit de 15 sccm au moins, n'incluant pas 0 sccm.
